# EUROPÄISCHE PATENTSCHRIFT

(11) **EP 3 221 904 B1**
(45) Veröffentlichungstag und Bekanntmachung des Hinweises auf die Patenterteilung: **19.01.2022**
(21) Anmeldenummer: 15766118.2
(22) Anmeldetag: 15.09.2015
(51) Int. Cl.: H01L 43/12

(54) **VERFAHREN UND VORRICHTUNG ZUR HERSTELLUNG EINER MAGNETFELDSENSORVORRICHTUNG SOWIE DIESBEZÜGLICHE MAGNETFELDSENSORVORRICHTUNG**
METHOD AND APPARATUS FOR MANUFACTURING A MAGNETIC SENSOR DEVICE, AND CORRESPONDING MAGNETIC SENSOR DEVICE
PROCÉDÉ ET DISPOSITIF DE RÉALISATION D'UN DISPOSITIF DE DÉTECTION DE CHAMP MAGNÉTIQUE ET DISPOSITIF DE DÉTECTION DE CHAMP MAGNÉTIQUE CORRESPONDANT

(30) Priorität: 19.11.2014 DE 102014116953
(43) Veröffentlichungstag der Anmeldung: 27.09.2017
(73) Patentinhaber: Sensitec GmbH, 35578 Wetzlar (DE)
(72) Erfinder: SCHMITT, Jochen, 35216 Biedenkopf (DE); PAUL, Johannes, 55128 Mainz (DE); LEHNDORFF, Ronald, 55130 Mainz (DE); WAHRHUSEN, Jürgen, 55437 Nieder-Hilbersheim (DE); GLENSKE, Claudia, 35638 Leun (DE)
(74) Vertreter: Spachmann, Holger
(86) Internationale Anmeldenummer: PCT/EP2015/071061
(87) Internationale Veröffentlichungsnummer: WO 2016/078793

(56) Entgegenhaltungen:
- DE-A1- 10 216 865
- US-A1- 2011 074 406
- US-A1- 2011 074 406
- US-A1- 2012 049 843

## Beschreibung

Die Erfindung betrifft ein Verfahren und eine Vorrichtung zur Herstellung einer Magnetfeldsensorvorrichtung. Insbesondere zielt die Erfindung auf eine permanente Magnetisierung mindestens einer ferromagnetischen Schicht in einer auf einem Chipsubstrat aufgebrachten Magnetfeldsensorvorrichtung, insbesondere ein gleichzeitiges Magnetisieren einer Mehrzahl von benachbarten ferromagnetischen Schichten in zwei oder mehreren Richtungen, um somit Magnetfeldsensorvorrichtungen hoher Empfindlichkeit und verbesserter Qualität bereitzustellen.

### STAND DER TECHNIK

Magnetoresistive Sensorvorrichtungen dienen der widerstandsbasierten Messung von Magnetfeldern und somit für eine indirekte Erfassung von weiteren physikalischen Größen wie beispielsweise Weg, Winkel oder Stromstärke. Eine derartige Sensorvorrichtung beruht auf einem magnetoresistiven Effekt, bei welchem eine Änderung des elektrischen Widerstands einer Chipstruktur durch Anlegen eines äußeren Magnetfelds hervorgerufen wird. In jüngster Zeit werden vermehrt Magnetfeldsensorvorrichtungen eingesetzt, die auf einem Riesenmagnetowiderstandseffekt (GMR-Effekt) oder einem Tunnelmagnetoeffekt (TMR-Effekt) beruhen. Diese umfassen einen Dünnschichtaufbau von nichtmagnetischen und magnetischen Materialien, bei welchen eine magnetische Kopplung bzw. ein Spin-Effekt durch die Schichten hindurch einen Einfluss auf den elektrischen Widerstand hat. Bei GMR- und TMR-basierten magnetoresistiven Schichtsystemen kann eine Veränderung von bis zu 5 % (GMR) bzw. bis zu 600 % (TMR) des elektrischen Widerstandes auf Basis eines externen Magnetfelds erreicht werden. Für die Herstellung von TMR-Sensoren wird ein Schichtaufbau von mindestens zwei ferromagnetischen und einer Isolatorschicht, die eine Tunnelbarriere darstellt, ausgebildet, so dass Elektronen zwischen den beiden ferromagnetischen Schichten durch die Isolatorschicht tunneln können. Im Falle eines TMR-Sensors ist die Isolatorschicht beispielsweise Al₂O₃ oder MgO, im Falle eines GMR-Sensors wird oft eine dünne leitfähige Schicht, z.B. Cu oder Ru verwendet. Der elektrische Widerstand des Tunnelelements hängt davon ab, wie die beiden ferromagnetischen Schichten zueinander magnetisiert sind. Sind die beiden ferromagnetischen Schichten parallel zueinander magnetisiert, ist der Widerstand minimal. Sind sie antiparallel zueinander magnetisiert, ist der Widerstand maximal. In der Praxis wird häufig die Magnetisierungsrichtung einer der beiden ferromagnetischen Schichten fixiert (gepinnt), so dass die Magnetisierung dieser Schicht nicht oder nur schwach auf äußere Felder reagiert. Diese Schicht wird Referenzschicht genannt, oder auch gepinnte Schicht bzw. permanent magnetisierte Schicht. Die andere Schicht wird dagegen so gestaltet, dass ihre Magnetisierung in definierter Weise dem äußeren Feld folgt. Diese Schicht wird Detektionsschicht oder freie Schicht genannt. Durch die Aufteilung in eine Referenzschicht und eine Detektionsschicht, die unterschiedlich auf äußere Felder reagieren, gelingt es, Widerstandsänderungen bei Veränderung von äußeren Feldern zu erhalten und eine sensorische Vorrichtung zu realisieren. Die Widerstandsabhängigkeit korreliert mit dem Winkel zwischen der Magnetisierungsrichtung der Detektionsschicht, die auch als "Freelayer" bezeichnet wird und der Magnetisierungsrichtung der Referenzschicht, des sogenannten "pinned layers".

Zur Herstellung derartiger Strukturen werden Dünnschichttechnologien eingesetzt. Im Rahmen des Herstellverfahrens kann die Richtung der Magnetisierung der Referenzschicht permanent eingestellt werden, was häufig als Pinning bezeichnet wird. Zum Pinnen der ferromagnetischen Schichten, die auch als Referenzschichten bezeichnet werden, wird in der Regel die ferromagnetische Schicht an eine antiferromagnetische Nachbarschicht gekoppelt. Zum Einstellen der Magnetisierungsrichtung wird das Widerstandselement über die sogenannte Blocking-Temperatur erhitzt, bei der die Austauschkopplung zwischen der antiferromagnetischen Schicht und der ferromagnetischen Schicht verschwindet, wobei in der Regel diese Temperatur niedriger als die Curie-Temperatur der ferromagnetischen Schichten ist. Nach Erwärmen oberhalb der Blocking-Temperatur und unterhalb der Curie-Temperatur werden die ferromagnetischen Schichten einem externen Magnetfeld ausgesetzt, welches diese in eine definierte Magnetisierungsrichtung zwingt. Diese Magnetisierungsrichtung bleibt erhalten, wenn bei angelegtem Magnetfeld die antiferromagnetische Schicht wieder abkühlt und die Blocking-Temperatur wieder unterschritten wird.

Es ist höchst wünschenswert, auf einem Chipsubstrat verschiedene Pinning-Richtungen individuell und unabhängig voneinander einstellen zu können, so dass mehr als eine einzelne Pinning-Richtung vorgebbar ist. Insbesondere in der Sensorik sind Wheatstone-Brücken sehr nützlich. Hierbei ist es ideal, wenn die vier Äste der Wheatstone-Brücken identisch geformt sind und sich nur in den Pinningrichtungen unterscheiden.

Aus dem Stand der Technik ist zur Herstellung von Pinning-Strukturen für die Bereitstellung von magnetoresistiven Sensoren bereits eine Vielzahl von unterschiedlichen Lösungen bekannt. So beschreibt beispielsweise die DE 10 2012 208 882 das Anlegen eines Magnetfelds planar zu einer Chipsubstratoberfläche, um eine homogene Pinning-Richtung auf dem gesamten Chipsubstrat bereitstellen zu können. In ähnlicher Weise wird in der DE 11 2009 001 140 bei Temperaturen zwischen 200 °C bis 350 °C ein externes Magnetfeld parallel zur Chipoberfläche aufgebracht, um die ferromagnetischen Schichten voreinzustellen. In der US 6 501 678 B1 wird beispielsweise eine Art Magnetfeldstempel vorgeschlagen, um komplexe Magnetfeldorientierungen innerhalb des Chipsubstrats bereitstellen zu können.

Alternativ hierzu gibt es Herstellverfahren, in denen Stromleiter auf der Chipsubstratoberfläche vorgesehen sind oder kurzfristig auf sie aufgebracht werden, um mithilfe eines Stromflusses diverse lokale Magnetfelder erzeugen zu können, um eine Magnetisierung der ferromagnetischen Schichten erreichen zu können. So beschreibt beispielsweise die WO 96/38738 die Einprägung eines Pinning-Stroms mithilfe eines Stromleiters, um eine Magnetisierung einzelner Schichtstreifen zu bewirken. Auch die DE 195 20 206 schlägt eine Leiterschicht zur Führung eines Einstellstroms vor, um eine Pinning-Richtung vorgeben zu können. Schließlich schlagen auch die US 5 561 368 und die DE 11 2010 003 705 komplexe Stromführungselemente vor, um verschiedene Pinning-Richtungen auf einem Chipsubstrat einprägen zu können. Auch wird ein lokales Erhitzen mittels eines Lasers unter Einprägung einer Magnetisierungsrichtung durch eine Leiterbahn in der DE 195 20 206 diskutiert, um komplexe Pinning-Muster in eine Magnetfeldsensorvorrichtung bereitstellen zu können.

In der US 2002 0180 433 A1 ist ein Verfahren zum Pinnen von GMR- oder TMR-basierten Widerstandselemente beschrieben, bei dem zunächst jeweils ein weichmagnetisches Strukturierungselemente als Flusskonzentrationselement in der Nähe eines Widerstandselements angeordnet wird, und parallel zu der Chipoberfläche ein Pinning-Magnetfeld eingekoppelt wird, so dass alle mit einem weichmagnetischen Strukturierungselement belegten Widerstandselemente in eine identische Magnetfeldrichtung gepinnt werden.

Aus der US 8 715 776 B2 geht ein gattungsgemäßes Pinningverfahren hervor, wobei Widerstandselemente durch eine Isolationsschicht getrennt von einer hartmagnetischen Schicht entweder überdeckt oder berandet wird, um alternierende ein Pinnen in einer Magnetisierungsrichtung in entgegengesetzter Polarisierung zu erreichen. Das Vorbehandlungs-Magnetfeld wird wiederum parallel zur Chipsubstratfläche eingekoppelt.

Die JP 2010 066 262 A und die parallele DE 10 2008 041859 A betrifft eine Magnetfeldsensorordnung zur Messung einer senkrecht auf einer Chipsubstratfläche stehenden Mess-Magnetfeldkomponente, wobei ein Flusskonzentrationselement vorgesehen ist, dass beim Einkoppeln der senkrechten Magnetfeldkomponente zueinander antiparallele, in der Chipsubstratfläche liegende Magnetfeldkomponenten erzeugt, die durch magnetoresistive Widerstandselemente detektierbar sind.

In der US 2006 0226 940 wird ein Pinningverfahren für GMR-Widerstandselemente beschrieben, bei der ein Chipsubstrat mit seiner Chipsubstratoberfläche parallel zu einer Magnetfeldachse einer supraleitenden Stromspule in das Zentrum der Spule eingebracht wird, um eine zur Substratoberfläche parallele Pinningachse des Stromspulen-Vorbehandlungs-magnetfelds zu definieren.

Durch die US 2011 0151 589 A1 ist ein Pinningverfahren von Widerstandselementen in zwei orthogonalen Richtungen offenbart, wobei rechteckförmige Widerstandselemente mit einem vordefinierten Längen-Breitenverhältnis in orthogonalen Reihen auf einem Chipsubstrat angeordnet sind, und ein parallel zum Chipsubstrat ausgerichtetes Vorbehandlungsmagnetfeld in einem Pinningwinkel 45° zu den orthogonalen Achsen eingekoppelt wird, um die orthogonalen Widerstandselemente-Reihen in orthogonalen Richtungen zu pinnen.

In der US 2011 0074 406 A1 ist ein gattungsgemäßes Pinningverfahren von Widerstandselementen dargestellt, bei dem Widerstandselemente mit verschiedenen Pinningrichtungen auf einer Widerstandsfläche vormagnetisiert werden können. Hierzu werden Gruppen von Widerstandselementen, die räumlich eng benachbart sind, mit einem rechtwinklig zur Chipebene ausgerichteten Pinning-Magnetfeld vormagnetisiert. Jedem Widerstandselement ist am Anfang und Ende des Widerstandselements ein Strukturierungselement angeordnet, so dass eine Vormagnetisierungsfeld parallel zur Chipsubstratoberfläche zwischen den beiden Strukturierungselemente jedes Widerstandselements geführt werden kann.

In der DE10216865 ist ein Wärmebehandlungsofen mit Magnetfeld offenbart.

Die vorgenannten, aus dem Stand der Technik bekannten Verfahren zum lokalen Pinnen von Schichtstreifen von magnetoresistiven Widerstandsstrukturen weisen den Nachteil auf, dass bei Anlegen eines externen Magnetfelds parallel zur Chipsubstratoberfläche alle Widerstandselemente in die gleiche Richtung gepinnt werden, oder zum Vorsehen von verschiedenen Richtungen sehr komplexe Leitungsstrukturen aufgebracht werden müssen, um durch einen Pinning-Einstellstrom eine Magnetisierung zu erreichen. Werden Pinning-Leiterstrukturen vorgesehen, so muss eine elektrische Kontaktierung während des Herstellverfahrens gegeben sein, so dass zusätzliche Prozessschritte und damit hohe Kosten für die Herstellung solcher Sensoren aufgewendet werden müssen.

Somit leiden die vorbekannten Herstellverfahren darunter, dass nur mit hohem Aufwand ein relativ großflächiges homogenes und unidirektionales Pinning erfolgen kann, so dass die resultierenden Sensoren eine geringe Auflösungsgenauigkeit, hohe Herstellkosten bzw. hohen Herstellaufwand aufweisen.

Ausgehend von dem vorgenannten Stand der Technik ergibt sich somit das Problem, magnetoresistive Sensorelemente höherer Qualität und Miniaturisierung kostengünstig herzustellen. Dies kann dadurch erreicht werden, dass die Referenzschichten unterschiedliche Pinning-Magnetisierungsrichtungen aufweisen, die einfach herzustellen sind. Eine weitere Aufgabe der Erfindung liegt darin, ein präzises und hochintegriertes Sensorelement bereitzustellen, das beispielsweise auf einem einzelnen Chipsubstrat Magnetfelder in 2D oder 3D-Richtungen messen kann.

Diese Aufgabe wird durch ein Herstellverfahren und eine Herstellvorrichtung nach den unabhängigen Ansprüchen gelöst. Vorteilhafte Weiterbildungen sind in den nachfolgenden Unteransprüchen beschrieben.

### OFFENBARUNG DER ERFINDUNG

Erfindungsgemäß wird ein Verfahren zur Herstellung einer magnetoresistiven Sensorvorrichtung vorgeschlagen, bei dem zum Pinnen, d.h. permanenten Magnetisieren mindestens einer ferromagnetischen Schicht in einer auf einem Chipsubstrat aufgebrachten Magnetfeldsensorvorrichtung folgende Schritte durchgeführt werden:
- Herstellung mindestens eines magnetoresistiven Widerstandselements auf einem Chipsubstrat, welches mindestens eine ferromagnetische Schicht und mindestens eine antiferromagnetische Schicht umfasst, wobei zwischen ferromagnetischer und antiferromagnetischer Schicht eine Austauschkopplung wirkt, welche bei Erreichen der Blocking-Temperatur verschwindet;
- Aufbringen von mindestens einem weichmagnetischen Strukturierungselement auf dem Chipsubstrat benachbart oder teilweise überlappend zu dem Widerstandselement;
- Erwärmen des Widerstandselements über die Blocking-Temperatur des Materials der antiferromagnetischen Schicht und Einkoppeln eines Vorbehandlungs-Magnetfeldes;
- Abkühlen des Widerstandselementes unterhalb der Blocking-Temperatur;
- Entfernen des Vorbehandlungs-Magnetfeldes.

In einem ersten Schritt wird auf einem Chipsubstrat mindestens ein, insbesondere eine Vielzahl von magnetoresistiven Widerstandselementen aufgebracht, vorzugsweise GMR- oder TMR-Widerstandselemente, die eine freie Schicht und eine Referenzschicht aufweisen, wobei die Referenzschicht aus mindestens einer ferromagnetischen Schicht besteht, die durch direkte Austauschkopplung an eine benachbarte antiferromagnetische Schicht gekoppelt ist. Zusätzlich wird mindestens ein weichmagnetisches Strukturierungselement, beispielsweise eine lithographisch strukturierte Nickel-Eisen-Legierung, aufgebracht, die benachbart oder teilweise überlappend zu den Widerstandselementen auf der Chipsubstratoberfläche aufgebracht ist. Dies kann beispielsweise durch elektrogalvanisches Abscheiden, durch Sputtern, durch ein Dampfabscheideverfahren oder ähnlichen aus der Chipstrukturierung bekannten Maßnahmen auf dem Chipsubstrat erfolgen. Zum Ausrichten der ferromagnetischen Schichten wird eine Temperatur höher als die Blocking-Temperatur angelegt, so dass die Austauschwechselwirkung zwischen der ferromagnetischen Schicht und der antiferromagnetischen Schicht verschwindet. Die ferromagnetische Schicht ist nun nicht mehr durch die benachbarte antiferromagnetische Schicht gepinnt und verhält sich ähnlich wie die freie Schicht. Anschließend erfolgt ein Einkoppeln eines externen Magnetfeldes, das im Folgenden Vorbehandlungs-Magnetfeld genannt wird, wobei die Feldlinien des Vorbehandlungs-Magnetfeldes durch das weichmagnetische Strukturierungselement so geführt werden, dass diese an geeigneter Stelle in das Widerstandselement austreten und dort eine auf Basis der geometrischen Struktur des Strukturierungselements einstellbare Magnetisierung der ferromagnetischen Schichten bewirken.

Das Vorbehandlungs-Magnetfeld wird erfindungsgemäß senkrecht zur Chipsubstratoberfläche in das Strukturierungselement eingekoppelt. Es können auch Winkel bis zu 45° zur Normalen der Chipsubstratoberfläche für die maximale Komponente des Vorbehandlungs-Magnetfelds angenommen werden. Hiernach erfolgen ein Abkühlen des Widerstandselements unterhalb der Blocking-Temperatur und ein Entfernen des Vorbehandlungs-Magnetfelds, so dass die Magnetisierung fixiert wird, wodurch ein Pinnen der ferromagnetischen Schicht abgeschlossen ist.

Anschließend kann optional vor einer Fertigstellung des Pinningvorgangs die weichmagnetische Strukturierung des Elements vom Chipsubstrat entfernt werden, beispielsweise durch ein Ätzen, Sputtern oder ähnliche selektiv materialabtragende Verfahren. Allerdings kann das bzw. können die Strukturierungselemente auch auf dem Chipsubstrat verbleiben, um beispielsweise als Leiterelement, Flussführungselement oder ähnliches verwendet zu werden.

Je nach Berandungsform des weichmagnetischen Strukturierungselements können beliebige Ausrichtungen eines Pinning-Magnetfelds durch die Streufelder des Strukturierungselements erreicht werden, um die einzelnen ferromagnetischen Schichten in individuelle Richtungen pinnen zu können. Hierdurch ergibt sich die Möglichkeit, beliebige Pinningrichtungen einzustellen. Das Sensorelement als Ganzes kann einem möglichst homogenen externen Magnetfeld (= Vorbehandlungs-Magnetfeld) zum Pinnen ausgesetzt werden, wobei aufgrund der Pole bzw. Berandungskanten des Strukturierungselements individuelle lokale Magnetisierungsrichtungen einstellbar sind. Das Strukturierungselement kann nach dem Einprägen des Pinning-Magnetfelds wieder entfernt werden und kann bevorzugt aus Nickeleisen bestehen. Zwischen den Widerstandselementen und dem Strukturierungselement kann eine Isolierschicht beispielsweise SiN mit einer relativ geringen Dicke von 30 nm bis 5 µm vorgesehen sein.

Aufgrund des lithographischen Herstellverfahrens kann das Strukturierungselement eine beliebige Ausdehnungsfläche und eine beliebige Strukturierung der Berandungsfläche, aus der das Pinning-Streumagnetfeld austritt, aufweisen. Somit können in einem einzelnen Prozessschritt unterschiedliche Pinning-Richtungen einer Wheatstone-Messbrückenstruktur vorgegeben werden. Hierdurch ist es möglich, Widerstandselemente der Wheatstone-Messbrücke beispielsweise interdigital miteinander räumlich benachbart aufzubauen, so dass sich Materialinhomogenitäten auf der Chipstruktur aufgrund der räumlich nahen Anordnung sich korrespondierender Widerstandselemente einer Messstruktur ausgleichen. Hierdurch werden temperaturabhängige Fehler oder Materialfehler praktisch kompensiert und eine erhöhte Genauigkeit ermöglicht. Ein einziges Strukturierungselement ist derart gestaltet, dass es zwei oder mehrere TMR- oder GMR-Widerstandselemente gleichzeitig pinnen kann. Erfindungsgemäß wird das weichmagnetische Strukturierungselement so angeordnet, dass das Vorbehandlungs-Magnetfeld in das Strukturierungselement senkrecht zur Chipoberfläche eingekoppelt wird und am Ort des Widerstandselements auch Magnetfeldkomponenten parallel zur Chipoberfläche erzeugt, die zumindest bereichsweise die ferromagnetische Schicht des Widerstandselements durchdringen. Das Vorbehandlungs-Magnetfeld ist ein homogenes Magnetfeld, das senkrecht auf die Chipsubstratoberfläche auftrifft, und das durch die Magnetfeldführungseigenschaft und die geometrische Gestaltung des Strukturierungselements in Form eines Streufelds auch parallel zur Chipoberfläche an Berandungskanten austritt und ein Pinning der benachbarten Widerstandselemente vornimmt. Hierdurch können beliebige Pinning-Richtungen im Widerstandselement vorgesehen sein, wodurch ein einzelnes Strukturierungselement mehrere Widerstandselemente gleichzeitig pinnen kann.

Erfindungsgemäß sind dem weichmagnetischen Strukturierungselement zwei oder mehrere Widerstandselemente zugeordnet, um eine Magnetisierung der zumindest einen ferromagnetischen Schicht der Widerstandselemente in die gleiche, parallel zur Chipsubstratoberfläche liegende Richtung vorzunehmen. Alternativ dazu können dem weichmagnetischen Strukturierungselement zwei oder mehrere Widerstandselemente zugeordnet sein, um eine Magnetisierung der zumindest einen ferromagnetischen Schicht des Widerstandselements in entgegengesetzten, parallel zur Chipsubstratoberfläche liegenden Richtungen vorzunehmen. Somit kann ein Strukturierungselement zwei oder mehreren Widerstandselementen gleichzeitig zugeordnet sein, wobei durch Ausbildung von Magnetpolen des Strukturierungselements ein Pinning in gleicher Richtung oder in verschiedenen, insbesondere antiparallelen Richtungen ermöglicht wird. So können zwei, sich gegenüberliegende Pole des Strukturierungselements einen 180° Austritt von Streumagnetfeldlinien bewirken, so dass ein Pinnen zweier Widerstandselemente, die beispielsweise einer unteren oder oberen Halbbrücke einer Wheatstone-Messbrücke zugeordnet sind, gleichzeitig ermöglicht wird. Da die entgegengesetzt gepinnten Widerstandselemente räumlich benachbart sind, bewirkt ein Temperaturdrift oder ein Materialfehler im Chipsubstrat identische Widerstandsänderungen, so dass diese sich in der Messbrücke kompensieren, wodurch der Brückenoffset minimiert wird. Eine Offset-Minimierung bewirkt eine erhöhte Genauigkeit der Magnetfeldsensormessbrücke. Insbesondere bei TMR-Widerstandselementen ist die Homogenität der Tunnelbarriere eine Schwachstelle bei den Herstellungsverfahren. Da die Schichtdicke der Tunnelbarriere exponentiell in den Widerstand des Tunnelelements eingeht, bewirken winzige Änderungen der Schichtdicke innerhalb einer Wheatstone-Brücke vergleichsweise große Offsetwerte der Brücke. Um diese Offset-Problematik zu minimieren, ist es vorteilhaft, die beiden Brückenäste räumlich so dicht wie möglich anzuordnen, da aufgrund der räumlichen Nähe, die Variationen der Barrierendicke am geringsten sind und die Brückenäste möglichst gleichartige Struktureigenschaften aufweisen.

Somit stehen erfindungsgemäß die eingestellte Magnetisierungsrichtung der ferromagnetischen Schichten der Widerstandselemente parallel oder antiparallel zueinander, abhängig von dem Verlauf der Kontur des Strukturierungselements und der räumlichen Lage der Widerstandselemente gegenüber dem Strukturierungselement.

In einer vorteilhaften Ausführungsform können die zumindest zwei oder mehrere Widerstandselemente zur Ausbildung einer Wheatstone-Messbrücke, bevorzugt zur Ausbildung zumindest eines oberen oder unteren Brückenzweigs einer Wheatstone-Messbrücke, genutzt werden. Hierzu bietet es sich an, insbesondere ein Strukturierungselement zum Pinning des oberen und ein Strukturierungselement zum Pinning des unteren Brückenzweigs einzusetzen, oder ein gemeinsames Strukturierungselement mit verschieden ausgeformten Polen zum gleichzeitigen Pinnen der Widerstandselemente des oberen und des unteren Brückenzweigs vorzusehen. Bevorzugt sind die Widerstandselemente, die den oberen Brückenzweig bilden, und die Widerstandselemente, die den unteren Brückenzweig bilden, auf dem Chipsubstrat räumlich benachbart angeordnet.

Vorteilhafterweise sind die Widerstandselemente derart eingerichtet, dass sie ein GMR-Schichtsystem bilden. Ein GMR-Schichtsystem (Giant-Magnetoresistance-Schichtsystem) bedeutet eine Struktur, die aus mindestens zwei ferromagnetischen Schichten bestehen, welche durch eine nichtmagnetische Metallschicht getrennt sind. Zwischen den beiden ferromagnetischen Schichten wirkt eine indirekte Austauschkopplung, die sogenannte RKKY Wechselwirkung. Der Widerstand des GMR-Widerstandselementes hängt von dem Winkel ab, in dem die Magnetiserungsrichtungen der ferromagnetischen Schichten zueinander stehen.

Alternativ kann die Magnetfeldsensorvorrichtung auch Widerstandselemente umfassen, die ein Tunnelwiderstandsschichtsystem (TMR-Schichtsystem) bilden. Ein TMR-System beruht darauf, dass zwischen zwei ferromagnetischen Schichten ein dünner Isolator mit einer Schichtdicke von 0,5 bis 3 nm vorhanden ist, so dass die Elektronen zwischen den ferromagnetischen Schichten tunneln können. Das vorgeschlagene Herstellverfahren kann somit besonders einfach und günstig für die Herstellung von GMR- oder TMR-Magnetfeldsensoren eingesetzt werden. Hierdurch können Magnetfeldsensorvorrichtungen für eine Kompassanwendung oder für einen Wegstreckenmesser, Winkelmesser oder dergleichen hergestellt werden.

In einer vorteilhaften Weiterbildung kann zumindest eine Berandungskante des weichmagnetischen Strukturierungselements im Wesentlichen parallel oder tangential zu einer Berandungskante eines Widerstandselements verlaufen, wobei das Widerstandselement bereichsweise vom weichmagnetischen Strukturierungselement überdeckt oder von ihm eingefasst ist, und wobei die Überdeckung ein Maß von 5 µm oder weniger aufweist. Es wird somit vorgeschlagen, zumindest eine Berandungskante des weichmagnetischen Strukturierungselements parallel oder tangential zu einer Kontur des Widerstandselements vorzusehen, so dass Magnetfelder, die durch das Strukturierungselement geführt und an den Berandungskanten austreten, unmittelbar im Widerstandselement eintreten und somit eine hohe Pinning-Wirkung der ferromagnetischen Schicht bewirken können. Hierdurch kann eine Kopplung des Pinning-Magnetfelds vom Strukturierungselement in das Widerstandselement verbessert und ein zuverlässiges Ausrichten der ferromagnetischen Layer erreicht werden.

Das Vorbehandlungs-Magnetfeld durchdringt das das Chipsubstrat im Wesentlichen senkrecht zur Chipsubstratobertläche, wobei im Bereich der Berandungskante eines weichmagnetischen Strukturierungselements magnetische Streufelder im wesentlichen parallel zur Chipsubstratoberfläche ausgerichtet sind, oder eine ausreichend starke Komponente parallel zur Chipsubstratoberfläche aufweisen. Die Magnetfeldlinien können somit auch bis zu einem 45° Winkel zur Chipsubstratoberfläche gerichtet sein. Es wird vorgeschlagen, dass das Vorbehandlung-Magnetfeld senkrecht über die Strukturierungselemente auf das Chipsubstrat ausgerichtet sein kann, wobei im Bereich der Berandungskanten magnetische Streufelder parallel zum Chipsubstrat streuen, und wobei unterhalb des Chipsubstrats der magnetische Gegenpol angeordnet ist, so dass die Streufelder nur eine lokal begrenzte Wirkung haben, und durch das Chipsubstrat hindurch auf den Gegenpol der Magnetfeld-Erzeugungseinrichtung geführt werden. Somit können viele verschieden ausgerichtete Streufelder durch das Strukturierungselement eng benachbart zueinander hervorgerufen werden, um unterschiedliche Pinning-Richtungen in hoher Dichte auf dem Chip vorsehen zu können.

Nach einer vorteilhaften Weiterbildung kann das weichmagnetische Strukturierungselement dahin gehend geformt sein, dass die Flussdichte der austretenden magnetischen Streufelder vorzugsweise durch ausgeprägte Polschuhe oder Flussführungsausnehmungen im Strukturierungselement geführt und verstärkt wird. Es wird vorgeschlagen, das Strukturierungselement entlang der Berandungskanten, aber auch an der der Chipsubstratoberfläche zugewandten Fläche derart auszuformen, dass ausgeprägte Polschuhe gebildet werden bzw. Flussführungsausnehmungen, wie Kanten, Stufen oder Abrundungen vorgesehen sind, um die Magnetfelder innerhalb des weichmagnetischen Strukturierungselements gezielt zu führen und zu bündeln, um einen hohen Streufeldaustritt an den gewünschten Berandungskanten ermöglichen zu können. Hierdurch werden relativ hohe Pinning-Magnetfeldstärken an den Berandungskanten ermöglicht und ein zuverlässiges Pinnen mit hoher und gleichbleibender Qualität erreicht.

In einer vorteilhaften Weiterbildung können die Widerstandselemente von dem weichmagnetischen Strukturierungselement durch eine Isolationsschicht, insbesondere durch eine Schicht von SiN oder Al₂O₃ mit einer Dicke von 30 nm bis 5 µm isoliert sein. Durch eine Isolationszwischenschicht zwischen Chipsubstrat, insbesondere Widerstandselementen und dem Strukturierungselement, ist das Aufbringen des Strukturierungselements vereinfacht und insbesondere das Ablösen des Strukturierungselements nach erfolgtem Pinning ohne Beschädigung der Widerstandselemente oder des Chipsubstrats einfach möglich. Hierdurch werden Verunreinigungen und Beschädigungen auf dem Chipsubstrat vermieden. Eine Schicht von SiN oder Al₂O₃ lässt sich mit einer relativ geringen Dicke von 30 nm bis 5 µm, maximal bis zu 10 µm leicht aufbringen, und schützt den Magnetfeldsensorchip vor und während dem Aufbringen und beim Entfernen des weichmagnetischen Strukturierungselements.

In einer vorteilhaften Weiterbildung kann das weichmagnetische Strukturierungselement durch Ablagern oder Aufbau einer Schicht weichmagnetischen Materials auf dem Chipsubstrat, insbesondere NiFe mit einer Schichtdicke von 1000 nm bis 20 µm, bevorzugt durch ein elektrogalvanisches oder ein Gasabscheideverfahren und einem lithographischen Strukturierungsverfahren zur Strukturierung einzelner weichmagnetischer Strukturierungskörper hergestellt werden. In der Galvanik wird in der Regel zunächst ein Seedlayer aufgebracht, auf dem eine Photostruktur aufgebracht wird. Hiernach werden durch eine Galvanisierungsschicht die Strukturierungskörper abgelagert, und hiernach der Seedlayer wieder entfernt. Es wird vorgeschlagen, das Strukturierungselement durch Abscheiden von NiFe mit einer Schichtdicke von 1000 nm bis 20 µm abzulagern, insbesondere mittels eines lithographischen Strukturierungsverfahrens und einer elektrogalvanischen Abscheidung oder einer Gasabscheidung abzulagern. Dabei kann nach einem großflächigen Abscheiden eine lithographische Strukturierung vorgenommen werden, um einzelne Strukturierungskörper auszubilden, und beispielsweise definierte Polschuhe oder Ähnliches und einen gewünschten Verlauf der Berandungskontur des Strukturierungselements auszubilden. Hiermit können bewährte Techniken zum Aufbringen der Strukturierungselemente eingesetzt werden, die ohne höhere Kosten und ohne großen Zeitaufwand in einem bereits existierenden Herstellverfahren mühelos integriert werden können.

Vorteilhafterweise können nach Fertigstellung des Pinningvorgangs das oder die weichmagnetischen Strukturierungselemente vom Chipsubstrat entfernt werden. Die Strukturierungselemente dienen dann nur als Herstell- und Opferschicht, die nachträglich nach dem Einkoppeln des Pinning-Magnetfelds wieder rückstandsfrei entfernt werden kann. Somit sind der Sensorstruktur keine Grenzen gesetzt und das Design und die Form der Magnetfeldsensorstrukturen können unabhängig von einer Form der Einkopplungs-Strukturierungselemente gewählt werden. Die Form der Strukturierungselemente kann somit optimal für den Einkoppelprozess des Pinningmagnetfelds gewählt werden, ohne Kompromisse bezüglich einer weiteren Verwendung der Strukturierungselemente machen zu müssen.

In einem nebengeordneten Aspekt betrifft die Erfindung eine Magnetfeld-Vorbehandlungsvorrichtung zur magnetischen Vorbehandlung von auf einem Chipsubstrat aufgebrachten Widerstandselementen einer Magnetfeldsensorvorrichtung. Die Magnetfeld-Vorbehandlungsvorrichtung umfasst einen Heizofen und eine Magnetfeld-Erzeugungsvorrichtung mit einem Pol und einer Gegenpoloberfläche im Inneren des Heizofens, wobei mindestens ein Chipsubstrat von mindestens einem weichmagnetischen Strukturierungselement zwischen Pol- und Gegenpoloberfläche einlegbar ist, um eine magnetische Vorbehandlung, insbesondere Pinning von auf dem Chipsubstrat angeordneten Widerstandselementen durch ein senkrecht auf die Chipsubstratoberfläche ausgerichtetes Vorbehandlungs-Magnetfeld zu erreichen. Vorzugsweise werden eine Mehrzahl von Chipsubstraten bzw. Wafern gleichzeitig gepinnt. Der Heizofen ist dazu geeignet, eine Temperatur jenseits der Blocking-Temperatur, aber unterhalb der Curie-Temperatur, der einzelnen Schichtstreifen der Widerstandselemente einzustellen, und ein Pinning durch Aufprägen eines externen Vorbehandlungs-Magnetfelds zu erreichen. Nach dem Aufbringen der Widerstandselemente auf der Chipsubstratoberfläche erfolgt ein Erhitzen und Pinnen innerhalb der Magnetfeld-Vorbehandlungsvorrichtung. Das Vorbehandlungs-Magnetfeld kann während des gesamten Erwärmungs- und Abkühlprozesses anliegen, oder kann selektiv bei Erreichen einer vorbestimmten Temperatur zu- und bei Unterschreiten einer weiteren vorbestimmten Temperatur abgeschaltet werden. Alternativ kann das Chipsubstrat bzw. der zu pinnende Wafer aus der Magnetfeldvorrichtung herausgenommen werden, um das externe Pinning-Magnetfeld zu entfernen. Hiernach erfolgt evtl. ein Ablösen der Strukturierungselemente, und in weiteren Prozessschritten wird die Fertigstellung der Magnetfeldsensorvorrichtung durchgeführt.

In einer vorteilhaften Weiterbildung kann die Magnetfeld-Erzeugungseinrichtung einen Permanentmagneten umfassen, der im Heizofen angeordnet ist, wobei eine Stärke des Vorbehandlungs-Magnetfelds über einen einstellbaren Luftspalt zwischen Permanentmagnet und Pol- und Gegenpoloberfläche mittels einer Luftspalt-Einstelleinrichtung einstellbar ist. Wird das Vorbehandlungs-Magnetfeld durch einen Permanentmagneten bereitgestellt, so kann in einem beliebigen Heizofen eine derartige Magnetfeld-Erzeugungseinrichtung eingesetzt werden, ohne eine zusätzliche Stromversorgung bereitstellen zu müssen. Die Stärke des Magnetfelds kann in diesem Fall durch die Einstellung eines Luftspalts mithilfe einer Luftspalt-Einstelleinrichtung vorgenommen werden, um die Stärke des Vorbehandlungs-Magnetfeldes einzustellen. Das Magnetfeld liegt während des Aufheiz- und Abkühlprozesses permanent an und kann beispielsweise in der Stärke durch Verändern eines Luftspalts variiert werden. Zwischen der Pol- und der Gegenpoloberfläche wird das vorgefertigte Chipsubstrat mit weichmagnetischen Strukturierungselementen eingesetzt, wobei der Heizofen auf eine Temperatur über der Blocking-Temperatur der antiferromagnetischen Schichten erhitzt wird, und unterhalb der Curie-Temperatur der ferromagnetischen Schichten bleibt, so dass ein zuverlässiges Pinnen der Magnetfeldsensorvorrichtung erreicht werden kann.

### ZEICHNUNGEN

Weitere Vorteile ergeben sich aus den vorliegenden Zeichnungsbeschreibungen. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- **Fig. 1a**: in einer perspektivischen Darstellung eine erste Ausführungsform eines Herstellschrittes gemäß des erfindungsgemäßen Herstellverfahrens;
- **Fig. 1b**: ein magnetisches Streufeld zum Pinnen einer Widerstandsstruktur gemäß einem Herstellschritt des erfindungsgemäßen Verfahrens;
- **Fig. 2**: verschiedene Darstellungen weichmagnetischer Strukturierungselemente zur Verwendung in einer Ausführungsform des erfindungsgemäßen Verfahrens;
- **Fig. 3**: Chipstruktur mit weichmagnetischen Strukturierungselementen zur Herstellung einer erfindungsgemäßen Messvorrichtung;
- **Fig. 4**: schematisches Schaltbild sowie Chipstruktur einer Ausführungsform einer erfindungsgemäßen Messvorrichtung;
- **Fig. 5**: Darstellung eines beispielhaften für das Verfahren vorteilhaften Schichtaufbaus;
- **Fig. 6**: schematisch eine Ausführungsform einer Magnetfeld-Vorbehandlungsvorrichtung gemäß einem Ausführungsbeispiel der Erfindung;
- **Fig. 7**: perspektivisch eine Ausführungsform einer magnetischen Vorbehandlungsvorrichtung gemäß der Erfindung;
- **Fig. 8**: in einer Seitendarstellung schematisch ein Pinning-Schritt gemäß verschiedener Ausführungsformen der Erfindung;
- **Fig. 9**: Schnittdarstellung eines Strukturierungsaufbaus nach Aufbringen eines weichmagnetischen Strukturierungselements im Rahmen einer Ausführungsform des erfindungsgemäßen Verfahrens.

In den Figuren sind gleichartige Elemente mit gleichen Bezugszeichen beziffert.

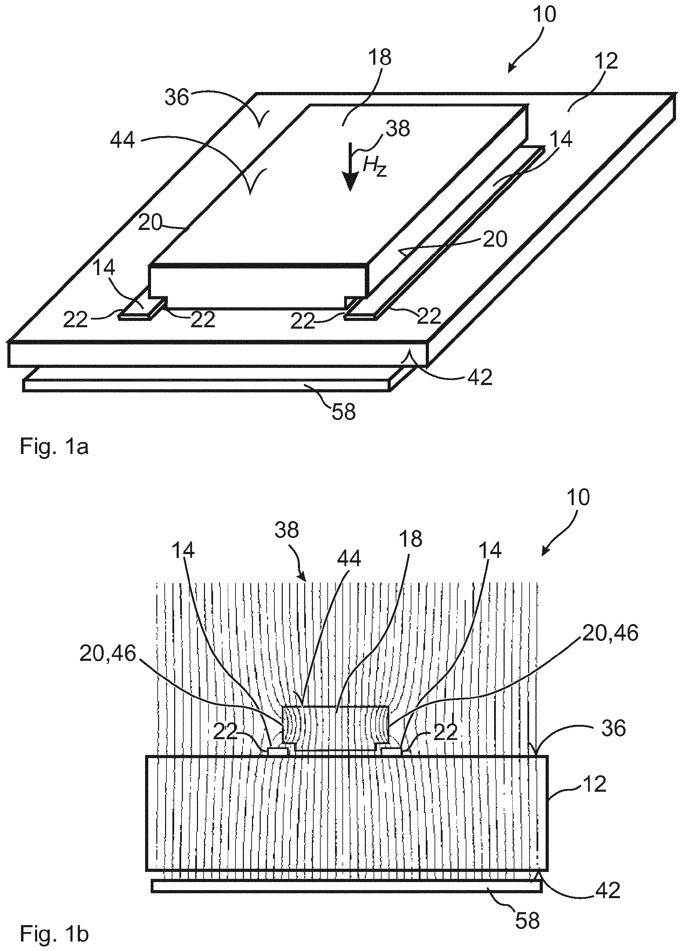

In der Fig. 1 ist eine perspektivische, schematische Darstellung zum Pinnen von Widerstandselementen 14 einer Magnetfeldsensorvorrichtung 10 dargestellt. Die Magnetfeldsensorvorrichtung 10 umfasst ein Chipsubstrat 12, auf dem Widerstandselemente 14 angeordnet sind. Die Widerstandselemente 14 bestehen aus einer Vielzahl von einzelnen dünnen ferro- und antiferromagnetischen Schichten, die aufeinandergestapelt sind, und die zu einer Wheatstone-Messbrücke verschaltet werden können. Zur magnetischen Vorausrichtung, dem sogenannten Pinnen der ferromagnetischen Schichten des Widerstandselements 14 wird ein Vorbehandlungs-Magnetfeld *H_{Z}* 38 eingesetzt, das senkrecht zur Oberfläche 36 des Chipsubstrats 12 ausgerichtet ist. Das Vorbehandlungs-Magnetfeld *H_{Z}* 38 wird von einem nicht dargestellten Magnetpol ausgesendet, durchdringt das Chipsubstrat 12 und wird von einer Gegenpoloberfläche 58, die unterhalb des Chipsubstrats 12 angeordnet ist, wieder aufgenommen. Das Vorbehandlungs-Magnetfeld *H_{Z}* 38 dringt senkrecht in ein weichmagnetisches Strukturierungselement 18 ein, wobei es rechtwinklig auf der Strukturierungsschicht-Oberfläche 44 ausgerichtet ist. Das Strukturierungselement 18 führt das Vorbehandlungs-Magnetfeld 38, so dass es, bedingt durch einen Abstand zum Chipsubstrat und durch eine erhöhte magnetische Leitfähigkeit durch die Widerstandselemente 14, an Berandungskanten 20 parallel zur Chipoberfläche 36 austritt und die Widerstandselemente 14 durchdringt. Ein verbessertes Durchdringen der Widerstandselemente 14 wird insbesondere dadurch erreicht, dass eine Temperatur oberhalb der Blocking-Temperatur der antiferromagnetischen Schichten des Widerstandselements eingestellt ist, so dass eine verbesserte Flussführung durch die Widerstandselemente 14 erfolgen kann. Die Berandungskanten 20 des Strukturierungselements 18 überlappen die Berandungskanten 22 der Widerstandselemente 14.

Eine entsprechende Magnetfeldschnittdarstellung zeigt die Fig. 1b, wobei die Magnetflussstreuung an den Berandungskanten 20 und das entsprechende Streumagnetfeld 46 des Strukturierungselements 18 dargestellt ist, das im Einfluss der Widerstandselemente 14 liegt. Deutlich zu sehen ist, dass die Berandungskanten 20 des Strukturierungselements 18 die Berandungskanten 22 des Widerstandselements 14 durchdringen. Das Widerstandselement 14 wird so in seiner gesamten Breite von Magnetfeldern durchsetzt, die auch eine Komponente in der Chipebene aufweisen. Letztlich werden die magnetischen Feldlinien durch das Chipsubstrat 12 auf die Gegenpoloberfläche 58 gelenkt, so dass verschiedene Pinning-Magnetfeldrichtungen in Abhängigkeit der Ausrichtung der Berandungskanten 20 der Strukturierungselemente 18 auf dem Chipsubstrat 12 einstellbar sind.

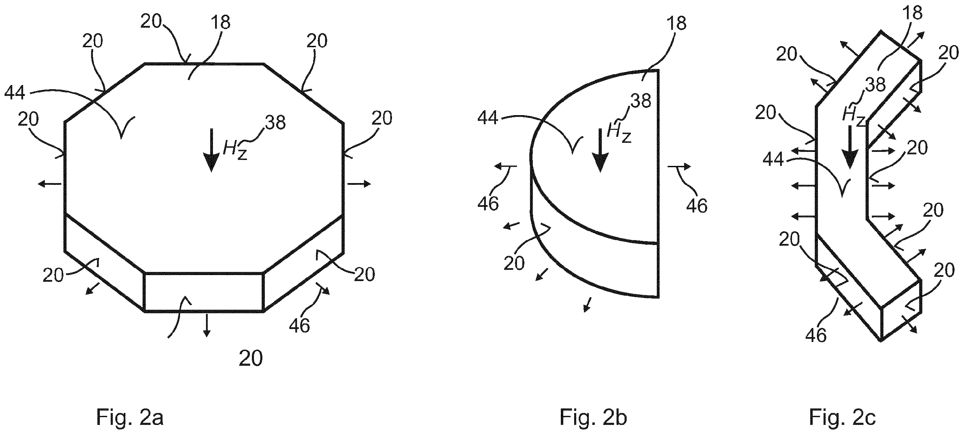

In den Fig. 2a bis 2c sind perspektivisch verschiedene weitere Ausführungsformen von möglichen weichmagnetischen Strukturierungselementen 18 dargestellt. Diese sind z.B. als 8-Eck nach Fig. 2a, als Halbscheibe nach Fig. 2b oder als abgewinkelter Schichtstreifen nach Fig. 2c ausgeführt. Strukturierungselemente 18 können eine Vielzahl polygonartig zueinander abgewinkelter oder gebogener Berandungskanten 20 aufweisen. Das Vorbehandlungs-Magnetfeld *H_{z}* 38 steht senkrecht auf der Strukturierungsschicht-Oberfläche 44, wobei Streumagnetfelder 46 normal zu der Berandungsoberfläche 20 der Strukturierungselemente 18 im Wesentlichen parallel zur Chipsubstratoberfläche austreten. Hierdurch lassen sich beliebige Pinning-Richtungen zur Herstellung einer Magnetfeldsensorvorrichtung 10 einstellen.

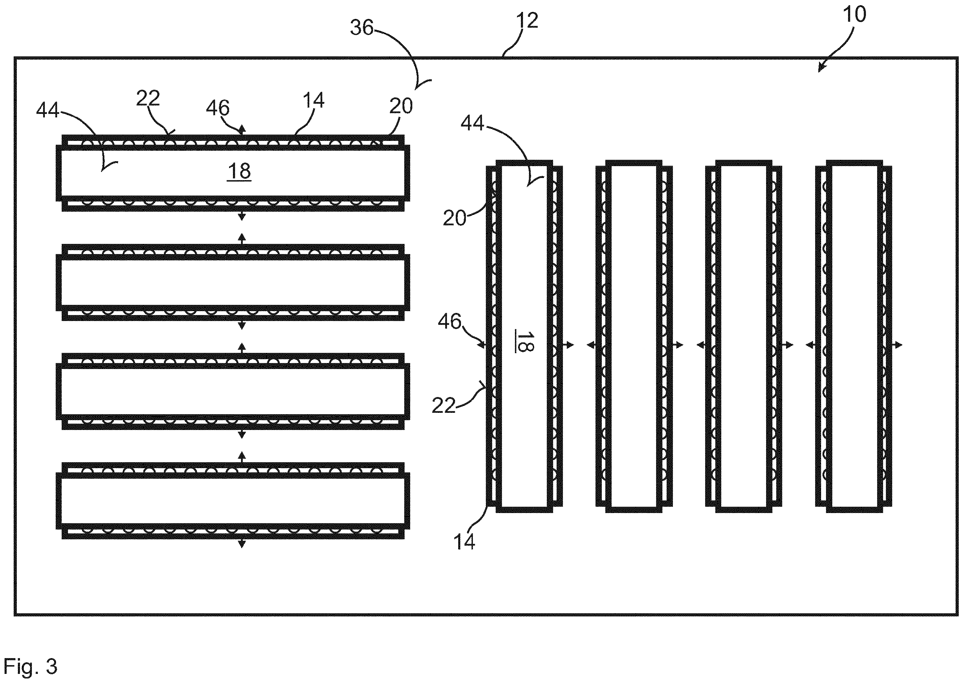

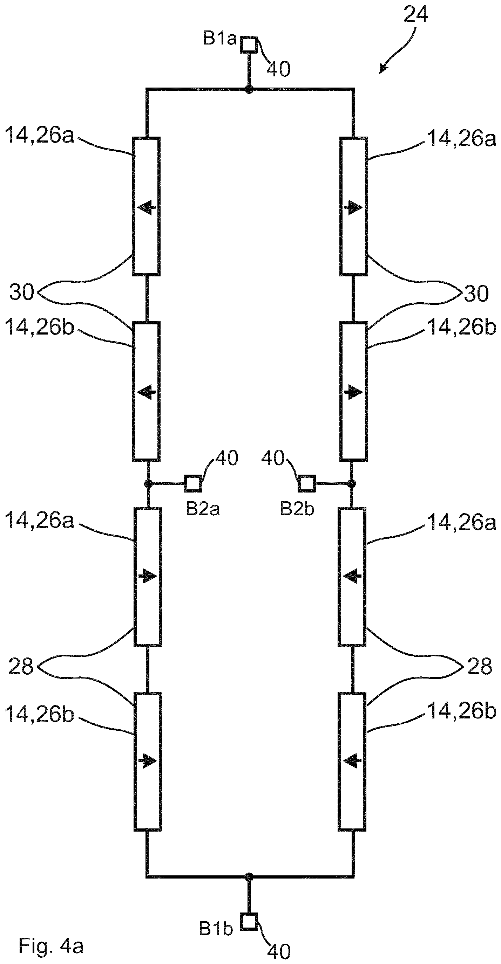

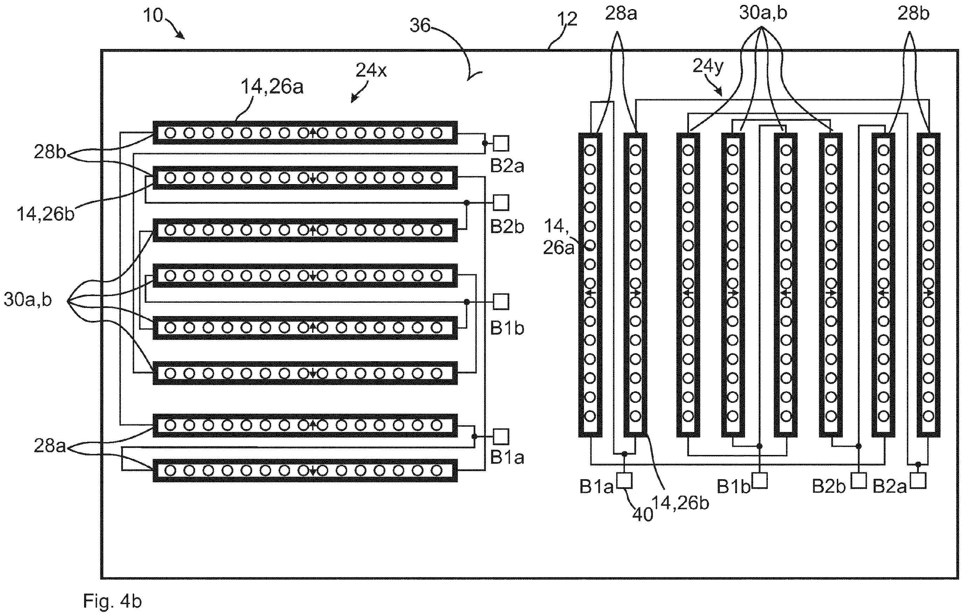

In den Figs. 3 und 4 ist die Herstellung zweier komplexer Wheatstone-Messbrücken zur Messung zweier rechtwinkliger Magnetfeldkomponenten X und Y einer Magnetfeldsensorvorrichtung 10 dargestellt. In der Fig. 3 ist der Pinning-Schritt einer Magnetfeldsensorvorrichtung 10 dargestellt, wobei auf einer Chipsubstratoberfläche 36 eines Chipsubstrats 12 eine Vielzahl von Widerstandselementen z.B. TMR-Widerstandselementen 14 angeordnet ist. Teilweise überlappend zu den Berandungskanten 22 der Widerstandselemente 14 sind weichmagnetische Strukturierungselemente 18 aufgebracht, deren Berandungskante 20 die Berandungskanten 22 der Widerstandselemente 14 zumindest teilweise überdecken. Durch Aufbringen eines senkrecht zur Chipsubstratoberfläche 36 gerichteten Vorbehandlungs-Magnetfeldes werden, wie mit den kleinen Pfeilen angedeutet, Berandungskanten-Streufelder 46 der Strukturierungselemente 18 erzeugt, die ein Pinnen der Widerstandselemente 14 durchführen.

In der Fig. 4a ist ein Schaltbild einer der beiden Wheatstone-Messbrücken der Magnetfeldsensorvorrichtung nach Fig. 3 dargestellt. Die Wheatstone-Messbrücke 24 besteht aus vier einzelnen Brückenwiderständen 26, wobei jeder Brückenwiderstand 26 aus zwei Widerstandselementen 14 besteht, und somit jeder Brückenwiderstand 26 aus jeweils einem Brückenwiderstandselement 26a und 26b, die in Reihe geschaltet sind, zusammengesetzt ist. Die Widerstandselemente 26a und 26b sind in gleicher Richtung gepinnt. Durch Versorgungspins B1a und B1b 40 kann ein Strom in die Messbrücke 24 eingeführt werden. Die Brückenwiderstände 26 der oberen Messbrücke 30 der beiden Brückenzweige sind in entgegengesetzter Richtung gepinnt. Das Gleiche gilt für die Brückenwiderstände 26 der unteren Messbrücke 28. Die Brückenwiderstände 26 der oberen Messbrücke 30 und der unteren Messbrücke 28 sind ebenfalls gegensinnig zueinander gepinnt. Durch Anlegen eines externen Magnetfelds werden die entsprechenden Widerstandswerte der Brückenwiderstände der oberen und unteren Messbrücke derart beeinflusst, dass sich eine deutliche Spannungsdifferenz an den Messkontakten B2a, B2b 40 ergibt, durch dessen Widerstandsänderung auf die Größe bzw. Winkel eines externen Magnetfelds zurückgeschlossen werden kann. Wie in Fig. 3 dargestellt, sind zwei Sets von Widerstandselementen 14, die zu den Brückenwiderständen 26 verbunden werden, auf einer Ebene des Chipsubstrats 12 angeordnet, wobei für eine 2D-Messung Widerstandselemente 14 für zwei Messbrücken 24 vorgesehen sind, die um 90° gegeneinander angeordnet sind.

Die Fig. 4b zeigt nach Entfernen der weichmagnetischen Strukturierungselemente 18 und einer elektrischen Verbindung der einzelnen Widerstandselemente 14 die schaltungstechnische Konfiguration, wie sie in Fig. 4a schematisch dargestellt ist. Es sind zwei Messbrücken 24x und 24y auf einem gemeinsamen Chipsubstrat 12 angeordnet, die über ein einheitliches Vorbehandlungs-Magnetfeld in X- und Y-Richtung gepinnt werden können. Hierzu ist, wie in Fig. 3 gezeigt, eine Vielzahl von weichmagnetischen Strukturierungselementen 18 vorgesehen, die jeweils zwei benachbarte Widerstandselemente 26a, 26b gegensinnig pinnen können, und die für die beiden Messbrücken 24x, 24y um 90° gegeneinander versetzt sind. Durch einen einheitlichen Pinning-Prozess durch Anordnen von weichmagnetischem Strukturelementmaterial und Einleiten eines homogenen Vorbehandlungs-Magnetfelds kann sehr einfach ein zuverlässiges Pinnen erreicht werden, wobei die zugeordneten Widerstandselemente 14 der Messbrücke 26 räumlich benachbart sind, um Temperaturdrifts oder Inhomogenitäten im Chipsubstrat gegenseitig kompensieren zu können. Hierdurch können hochpräzise Brückenschaltungen bereitgestellt werden, die nur eine geringe Drift und eine hochsensitive Widerstandsänderung bei Anlegen von zweidimensionalen Magnetfeldern aufnehmen können.

Die dargestellten zwei Wheatstone-Messbrücken für eine 2D-Magnetfeldsensorvorrichtung können für einen Winkelsensors eingesetzt werden. Durch das Einkoppeln des Vorbehandlungs-Magnetfelds 38 out-of-plane, d.h. senkrecht zur Chipsubstratoberfläche 36, können komplexe Pinning-Richtungen vorgegeben werden. Die beiden Wheatstone-Messbrücken liefern bei einer 360°-Drehung eines äußeren Magnetfelds in-plane ein sinusförmiges Ausgangssignal. In den beiden Messbrücken 24x und 24y werden durch die unterschiedlichen Pinning-Richtungen um 90° phasenverschobene Sinus- und Cosinus-Signale erzeugt. Wie in den Figs. 2a - 2c dargestellt, können die Strukturierungselemente 18 beliebige geometrische Formen aufweisen und müssen nicht zwangsläufig 90° oder 180° zueinander versetzte Pinning-Richtungen bereitstellen.

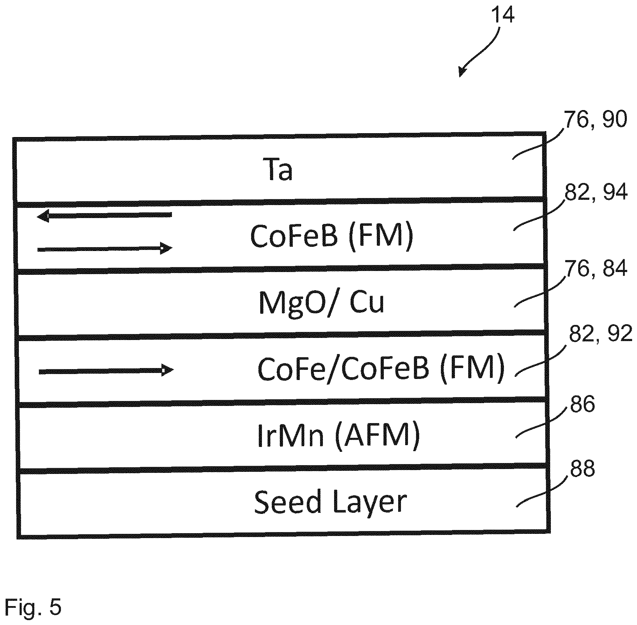

In Fig. 5 sind Beispiele für Schichtstapel eines Widerstandselements 14 dargestellt, dessen Schichtaufbau besonders für die erfindungsgemäße Einstellung der Magnetisierungsrichtung der sog. simple-spin-valve-Referenzschicht geeignet ist. Auf eine Startschicht (Seedlayer) 88,.die auch als elektrische Kontaktschicht dienen kann, wird der Pinnedlayer aufgebracht, der lediglich aus einer antiferromagnetischen Schicht (AFM) 86 mit angekoppelter ferromagnetischer Schicht (FM) 82 als Referenzschicht 92 besteht. Darüber befindet sich je nach MR-Technologie entweder eine dünne metallische, unmagnetische Zwischenschicht z.B. Cu (GMR) 84 oder ein dünne Isolierschicht z.B. MgO (TMR) 76. Darüber ist die freie ferromagnetische Schicht (FM) 82 als Detektionsschicht 94 angeordnet, die letztlich von einer Schutzschicht 90 z.B. Ta abgedeckt wird.

Zum Einstellen der Magnetisierungsrichtung wird der Schichtstapel des Widerstandselements 14 über die Blocking-Temperatur erhitzt, bei der die Austauschkopplung zwischen der antiferromagnetischen Schicht 86 und der Referenzschicht 92 verschwindet und der Schichtstapel wird einem externen Vorbehandlungsmagnetfeld ausgesetzt. Durch die (hier nicht gezeigten) Strukturierungselemente 18 werden Magnetfeldkomponenten parallel zu den Schichtebenen erzeugt, welche in der Referenzschicht 92 die gewünschte Magnetisierung einstellen. Nach Abkühlen des Schichtstapels unter die Blocking-Temperatur setzt die Kopplung der Referenzschicht 92 mit der antiferromagnetischen Schicht 86 wieder ein und eine stabile Magnetisierung in der Referenzschicht 92 bleibt auch nach Ausschalten des Vorbehandlungsmagnetfeldes erhalten. Das Pinning dient dazu, die Magnetisierung der Referenzschicht 92 einzustellen.

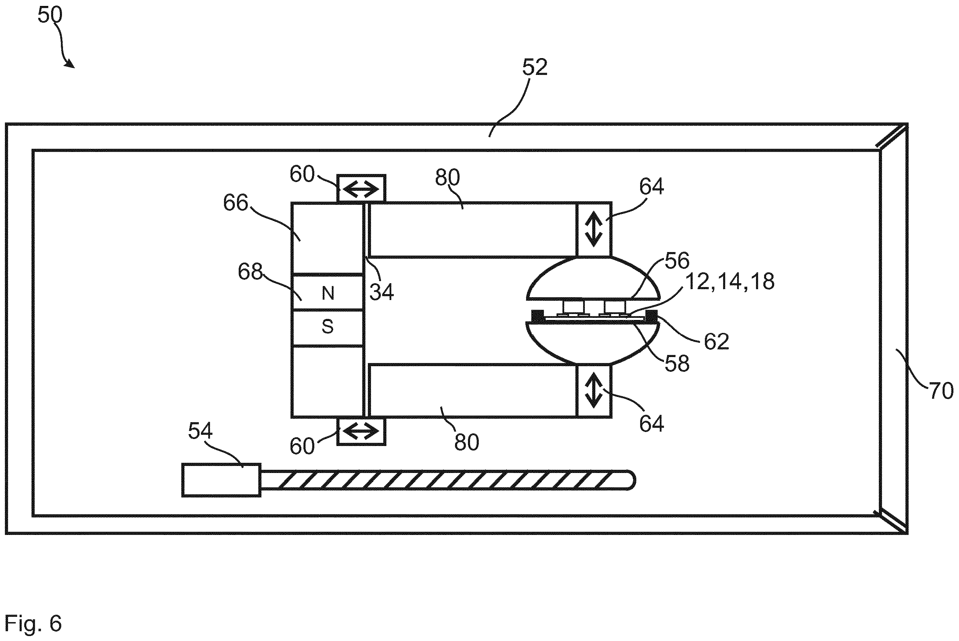

In der Fig. 6 ist eine Magnetfeld-Vorbehandlungsvorrichtung 50 dargestellt, die ein Heizofen 52 und eine Magnetfeld-Erzeugungseinrichtung 66 umfasst. Der Heizofen 52 weist eine Tür 70 auf, die offen- und wiederverschließbar ist, und durch welche die gesamte Magnetfeld-Erzeugungseinrichtung 66 entnommen werden kann. Mittels einer beispielsweise elektrisch betreibbaren Heizungseinrichtung 54 kann das Innere des Heizofens auf eine Temperatur oberhalb der Blocking-Temperatur, bevorzugt oberhalb 200 °C erhitzt werden. Die Magnetfeld-Erzeugungseinrichtung 66 umfasst einen Permanentmagneten 68, der über ein Magnetjoch aus einzelnen ferromagnetischen Bauteilen besteht, die zu einer Poloberfläche 56 und einer Gegenpoloberfläche 58 führen. Das Magnetfeld des Permanentmagneten 68 wird durch ein Eisenjoch 80 geführt und durchdringt den Luftspalt zwischen Poloberfläche 56 und Gegenpoloberfläche 58. Zum Regulieren der Stärke des Vorbehandlungs-Magnetfelds 38 ist eine Luftspalt-Einstelleinrichtung 60 vorgesehen, durch die ein variabler Luftspalt 34 im Eisenjoch 80 eingestellt werden kann, um somit die Stärke des zwischen Pol- und Gegenpoloberfläche 56, 58 sich einstellenden Vorbehandlungs-Magnetfelds 38 variieren zu können. Zur verbesserten magnetischen Kontaktierung einer Magnetfeldsensorvorrichtung auf einem Chipsubstrat 12 mit Widerstandselementen 14 und weichmagnetischen Strukturierungselementen 18 ist eine Polabstands-Einstelleinrichtung 64 vorgesehen, die für eine zuverlässige Zuführung des Vorbehandlungs-Magnetfelds 38 in die weichmagnetischen Strukturierungselemente 18 dient.

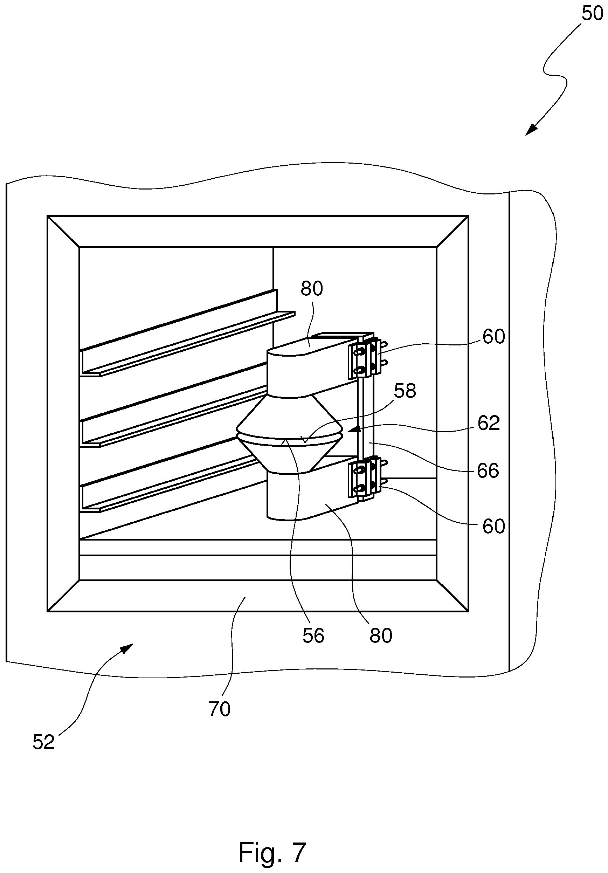

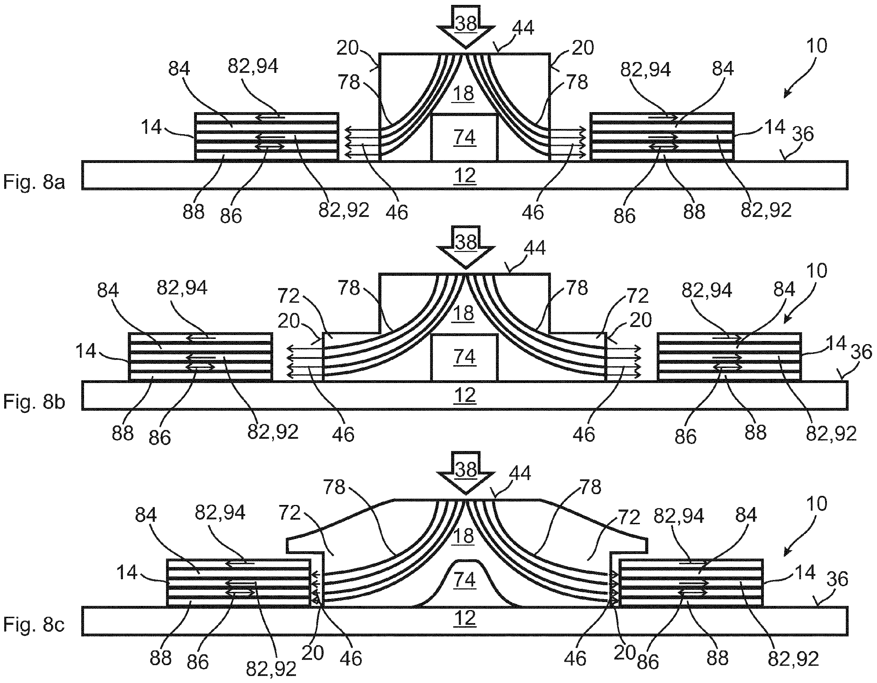

Ein Ausführungsbeispiel einer in Fig. 6 schematisch dargestellten Magnetfeld-Vorbehandlungsvorrichtung 50 ist in Fig. 7 in Verbindung mit einem Heizofen 52 perspektivisch dargestellt. In den Fig. 8a bis 8c sind in Seitendarstellungen schematisch das Einkoppeln des Pinning-Magnetfelds im Rahmen eines Herstellverfahrens einer Magnetfeldsensorvorrichtung 10 dargestellt. Die Magnetfeldsensorvorrichtung 10 umfasst ein Chipsubstrat 12, in dem Widerstandselemente 14 als TMR-Stapel mit einer Vielzahl dünner ferro- und antiferromagnetischer Schichten aufgebracht sind. Jedes Widerstandselement 14 umfasst eine Kontaktschicht 88 zur Zuführung elektrischen Stroms, eine antiferromagnetische Schicht 86 sowie zwei ferromagnetische Schichten 82, eine unmittelbar an die Schicht 86 angrenzende Referenzschicht 92 und eine Detektionsschicht 94, die durch eine unmagnetische Schicht 84 von der Referenzschicht 92 getrennt ist. Ein Vorbehandlungs-Magnetfeld 38 dringt senkrecht über die Oberfläche 44 in ein Strukturierungselement 18 ein, wobei das Strukturierungselement 18 eine Führung des Magnetflusses 78 bewirkt, so dass ein Streumagnetfeld 46 durch Berandungskanten 20 austritt, das in die Widerstandselemente 14 eindringt und die magnetische Ausrichtung der ferromagnetischen Schichten 82, insbesondere der Referenzschicht 92 bewirkt. Die Oberfläche 44 kann planar, gekrümmt oder andersartig gestaltet sein. Es können bereits untere und obere Kontaktschichten zum elektrischen Kontaktieren der Widerstandsschichten 14 angeordnet sein.

In der Fig. 8a ist das Strukturierungselement 18 U-förmig ausgebildet und weist eine Flussführungsausnehmung 74 auf, der der Magnetfluss 78 ausweicht und somit konzentriert geführt wird. Hierdurch wird der Magnetfluss 78 verstärkt zu den Berandungskanten 20 geführt und tritt als Streufluss 46 aus. Der Magnetfluss 78 ist in den Darstellungen der Fig. 8 nur schematisch und vereinfacht dargestellt, um die grundsätzlich zu erreichende Wirkungsweise darzustellen. Die gezeigten Abmessungen und Flussverläufe dienen lediglich zur Illustration des zugrundeliegenden Prinzips.

In der Fig. 8b ist das Strukturierungselement 18 derart ausgeformt, dass dedizierte Polschuhe 72 ausgebildet werden, die ein Führen des Streufelds 46 in die benachbarte Nähe des Widerstandselements 14 bewirken und eine erhöhte Konzentration des Streufelds 46 bewirken, um ein vollständiges Pinnen der ferromagnetischen Schichten 82, insbesondere der Referenzschicht 92 zu erreichen.

Schließlich ist in der Fig. 8c das Strukturierungselement 18 komplex aufgebaut, weißt eine Flussführungsausnehmung 74 sowie überlappende Polschuhkanten 72 auf, um eine verbesserte Ankopplung der Flussführung 78 in das Innere des Widerstandselements 14 zu erreichen.

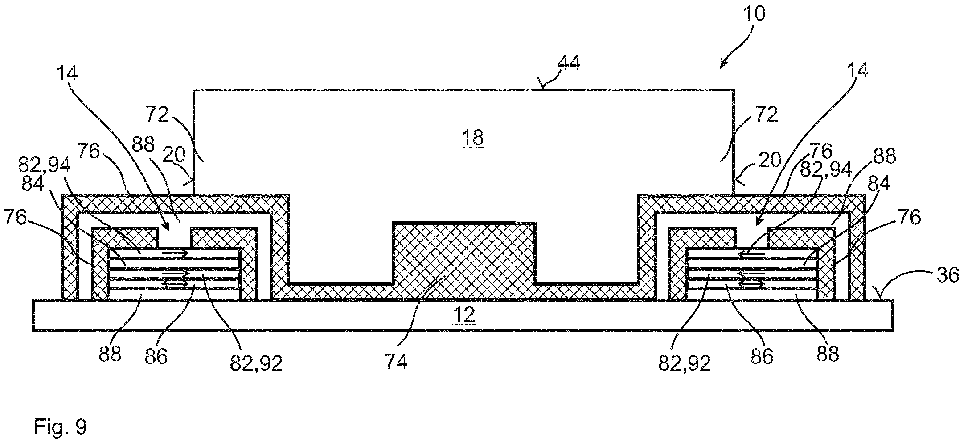

In der Fig. 9 ist in einer Schnittdarstellung ein Ausführungsbeispiel eines erfindungsgemäßen Herstellverfahrens dargestellt. Ein weichmagnetisches Strukturierungselement 18 ist auf einem Chipsubstrat 12 angeordnet, wobei es von Widerstandselementen 14 durch eine Isolationsschicht 76 beabstandet ist. Die Widerstandselemente 14 bestehen aus einem Schichtstapel von ferromagnetischen Schichten 82, die als Referenz- und Detektionsschicht 92, 94 dienen, einer unmagnetische Zwischenschicht 84 und einem Antiferromagnet 86, die mit Kontaktschichten 88 kontaktiert sind. Darüber befindet sich die Isolationsschicht 76 über die ein Strukturierungselement 18 aufgebracht ist. Das Strukturierungselement 18 weist eine Flussführungsausnehmung 74 und Polschuhe 72 auf, um eine Führung des resultierenden Pinningmagnetfelds in die Widerstandselemente 14 zu erreichen. Durch Beaufschlagung mit einem senkrecht zur Chipoberfläche 36 gerichteten Magnetfeld werden Streufeldlinien über die Polschuhe 72 des Strukturierungselements 18 in die Widerstandselemente 14 eingeleitet, um die ferromagnetischen Schichten 82, insbesondere die Referenzschicht 92 auszurichten. Nach dem Pinning kann das Strukturierungselement 18 beispielsweise durch Ätzen oder durch ein anderes Abtragungsverfahren wieder entfernt werden und die Herstellung der Magnetsensorvorrichtung 10 abgeschlossen werden.

Das wirksame Pinning-Magnetfeld am Ort der Referenzschicht kann nur eine geringe Stärke von typisch 100 mT oder weniger betragen, was zum Pinnen eines simple-Spin-Valve-Schichtaufbaus jedoch ausreicht. Ein derartiger künstlicher Antiferromagnet im Referenzlayer benötigt zum Pinnen allerdings üblicherweise deutlich höhere Felder und lässt sich nicht durch derartig schwache Felder pinnen. Als künstlicher Antiferromagnet wird ein Schichtaufbau verstanden, bei dem 2 oder mehrere ferromagnetische Schichten durch eine dünne nicht magnetische Zwischenschicht getrennt sind, wobei zwischen den ferromagnetischen Schichten eine Austauschkopplung zur Ausrichtung der Magnetisierung in den ferromagnetischen Schichten wirkt. Somit umfasst ein künstlicher Antiferromagnet eine Folge von zumindest zwei dünnen Schichten aus magnetischem und nichtmagnetischem leitenden Material, z.B. Co und Cu, deren dünnen magnetischen Schichten alternierend magnetisiert sind und somit kein resultierendes äußeres Magnetfeld erzeugt. Durch Verwendung eines nicht ausbalancierten, d.h. unterschiedliche ferromagnetische Schichtdicken aufweisenden künstlichen Antiferromagneten in der Referenzschicht kann ein derartiger Schichtaufbau jedoch auch bei diesen niedrigen Feldstärken bei Temperaturen oberhalb der Blocking-Temperatur gepinnt werden.

Das Strukturierungselement 18 kann durch ein Plating-Verfahren abgeschieden werden und ist üblicherweise zwischen 1 µm und 20 µm hoch. Hierzu wird insbesondere eine NiFe-Struktur, beispielsweise aus NiFe 8020 eingesetzt. Das zu pinnende Widerstandselement 14 ist eng benachbart zur Berandungskante 20 des Strukturierungselements 18. Es können Bereiche von ca. 5 µm gepinnt werden, wobei die zu pinnenden Bereiche teilweise von dem Strukturierungselement 18 überdeckt werden können. Entgegengesetzt gepinnte Widerstandselemente 14 können sehr eng zueinander benachbart sein. Dabei weisen die Widerstandselemente 14 identische Materialeigenschaften, wie zum Beispiel Barrierenwiderstand und TMR-Effekte auf. Somit können parallele Wheatstone-Brückenäste identisch mit unterschiedlichen Pinning-Richtungen aufgebaut sein, um einen optimierten Offset-Wert zu erreichen. Die Isolationsschicht kann beispielsweise aus SiN oder Al₂O₃ mit einer Schichtdicke von 30 nm bis 5000 nm bestehen. Nach dem Aufbringen eines Seed Layers können durch ein elektrogalvanisches Verfahren die weichmagnetischen Strukturierungselemente 18 aufgebaut werden. Durch ein Strukturierungsverfahren können die Strukturierungselemente 18 ausgeformt und einem senkrechten Vorbehandlungs-Magnetfeld ausgesetzt werden, um ein Pinnen vorzunehmen. Nach dem Entfernen des weichmagnetischen Strukturierungselements 14 kann die Isolationsschicht 76 selektiv geöffnet werden, um die Widerstandselemente 14 elektrisch kontaktieren zu können. Im Gegenstand zu klassischen Pinning-Vorrichtungen, in denen Magnetfelder parallel zur Chipoberfläche in-plane angelegt werden, kann mithilfe der vorgeschlagenen Magnetfeld-Vorbehandlungsvorrichtung 50 mittels eines senkrecht zur Chipoberfläche 36 ausgerichteten Magnetfelds 38 ein Pinning vorgenommen werden. Durch einen einstellbaren Luftspalt 34 kann die Stärke des Vorbehandlungs-Magnetfelds justiert werden.

### Bezugszeichenliste

- 10: Magnetfeldsensorvorrichtung
- 12: Chipsubstrat
- 14: Widerstandselement

- 18: weichmagnetisches Strukturierungselement
- 20: weichmagnetische Berandungskante
- 22: Berandungskante des Widerstandselements
- 24: Wheatstone-Messbrücke
- 26: Brückenwiderstand
- 28: Unterer Brückenzweig
- 30: Oberer Brückenzweig
- 32 34: Einstellbarer Luftspalt
- 36: Chipsubstratoberfläche
- 38: Vorbehandlungs-Magnetfeld
- 40: Messbrücke-Kontaktfläche
- 42: Chipsubstrat-Unterseite
- 44: Weichmagnetische Strukturierungsschicht-Oberfläche
- 46: Berandungskanten-Streufeld
- 48 50: Magnetfeld-Vorbehandlungsvorrichtung
- 52: Heizofen
- 54: Heizungseinrichtung
- 56: Poloberfläche
- 58: Gegenpoloberfläche
- 60: Luftspalt-Einstelleinrichtung
- 62: Chipsubstrat-Halteeinrichtung
- 64: Polabstands-Einstelleinrichtung
- 66: Magnetfeld-Erzeugungseinrichtung
- 68: Permanentmagnet
- 70: Tür des Heizofens
- 72: Polschuh
- 74: Flussführungsausnehmungen
- 76: Isolationsschicht
- 78: geführter Magnetfluss
- 80: Eisenjoch
- 82: ferromagnetische Schicht
- 84: Zwischenschicht
- 86: antiferromagnetische Schicht / Antiferromagnet
- 88: Kontaktschicht
- 90: Schutzschicht / Isolierschicht
- 92: Referenzschicht
- 94: Detektionsschicht

## Patentansprüche

1. Verfahren zur permanenten Magnetisierung mindestens einer ferromagnetischen Schicht in einer auf einem Chipsubstrat (12) aufgebrachten Magnetfeldsensorvorrichtung (10) umfassend die Schritte:
- Herstellung mindestens eines magnetoresistiven Widerstandselements (14) auf einem Chipsubstrat (12), welches mindestens eine ferromagnetische Schicht und mindestens eine antiferromagnetische Schicht umfasst, wobei zwischen ferromagnetischer und antiferromagnetischer Schicht eine Austauschkopplung wirkt, welche bei Erreichen der Blocking-Temperatur verschwindet;
- Aufbringen von mindestens einem weichmagnetischen Strukturierungselement (18) auf dem Chipsubstrat (12) benachbart oder teilweise überlappend zu dem Widerstandselement (14);
- Erwärmen des Widerstandselementes (14) über die Blocking-Temperatur des Materials der antiferromagnetischen Schicht und Einkoppeln eines Vorbehandlungs-Magnetfeldes (38);
- Abkühlen des Widerstandselementes (14) unterhalb der Blocking-Temperatur;
- Entfernen des Vorbehandlungs-Magnetfeldes (38), wobei das weichmagnetische Strukturierungselement (18) so angeordnet ist, dass das eingekoppelte Vorbehandlungs-Magnetfeld (38) das Strukturierungselement (18) im Wesentlichen senkrecht zur Chipoberfläche (36) durchdringt und am Ort des Widerstandselementes (14) Magnetfeldkomponenten parallel zur Chipoberfläche erzeugt, die zumindest bereichsweise die ferromagnetische Schicht des Widerstandselementes (14) durchdringen,
**dadurch gekennzeichnet, dass** dem weichmagnetischen Strukturierungselement (18) zwei oder mehrere Widerstandselemente (14) zugeordnet sind, um eine permanente Magnetisierung der zumindest einen ferromagnetischen Schicht der Widerstandselemente (14) in die gleiche oder in verschiedene, parallel zur Chipsubstratoberfläche (36) liegende Richtung vorzunehmen.

2. Verfahren nach Anspruch 1, **dadurch gekennzeichnet, dass** die eingestellten Magnetisierungsrichtungen der ferromagnetischen Schichten der Widerstandselemente (14) entweder parallel oder antiparallel zueinander stehen.

3. Verfahren nach einem der vorhergehenden Ansprüche, **dadurch gekennzeichnet, dass** die zumindest zwei oder mehreren Widerstandselemente (14) zur Ausbildung einer Wheatstone-Messbrücke (24), bevorzugt zur Ausbildung zumindest eines oberen oder unteren Brückenzweigs (28, 30) einer Wheatstone-Messbrücke (24) einsetzbar sind.

4. Verfahren nach einem der vorhergehenden Ansprüche, **dadurch gekennzeichnet, dass** die Widerstandselemente (14) GMR-Schichtsysteme und/oder TMR-Schichtsysteme umfassen.

5. Verfahren nach einem der vorhergehenden Ansprüche, **dadurch gekennzeichnet, dass** zumindest eine Berandungskante (20) des weichmagnetischen Strukturierungselementes (18) im Wesentlichen parallel oder tangential zu einer Berandungskante (22) eines Widerstandselementes (14) verläuft, wobei das Widerstandselement (14) bereichsweise vom weichmagnetischen Strukturierungselement (18) überdeckt ist, und wobei die Überdeckung eine Maß von 5 µm oder weniger beträgt.

6. Verfahren nach einem der vorhergehenden Ansprüche, **dadurch gekennzeichnet, dass** das Strukturierungselement (18) dahingehend geformt ist, dass die Flussdichte der austretenden magnetischen Streufelder (46) vorzugsweise durch ausgeprägte Polschuhe (72) oder Flussführungsausnehmungen (74) im Strukturierungselement geführt und verstärkt wird.

7. Verfahren nach einem der vorhergehenden Ansprüche, **dadurch gekennzeichnet, dass** die Widerstandselemente (14) von dem weichmagnetischen Strukturierungselement (18) durch eine Isolationsschicht (76), insbesondere einer Schicht aus SiN oder Al₂O₃ mit einer Dicke von 30 nm bis 5 µm isoliert sind.

8. Verfahren nach einem der vorhergehenden Ansprüche, **dadurch gekennzeichnet, dass** das weichmagnetische Strukturierungselement (18) durch Ablagern oder Aufbauen einer Schicht weichmagnetischen Materials auf dem Chipsubstrat (12), insbesondere NiFe mit einer Schichtdicke von 1000 nm bis 20 µm, bevorzugt durch ein elektrogalvanisches Abscheideverfahren und lithographischen Strukturierungsverfahren zur Strukturierung einzelner weichmagnetischer Strukturierungselemente (18) hergestellt wird.

9. Verfahren nach einem der vorhergehenden Ansprüche, **dadurch gekennzeichnet, dass** nach Fertigstellung des Pinningvorgangs das oder die weichmagnetischen Strukturierungselemente (18) vom Chipsubstrat (12) entfernt werden.

10. Magnetfeld-Vorbehandlungsvorrichtung (50) zur permanenten Magnetisierung (Pinning) mindestens einer ferromagnetischen Schicht von auf einem Chipsubstrat (12) aufgebrachten Widerstandselementen (14) einer Magnetfeldsensorvorrichtung (10) durch ein vorgenanntes Verfahren **dadurch gekennzeichnet, dass** die Magnetfeld-Vorbehandlungsvorrichtung (50) einen Heizofen (52) und eine Magnetfeld-Erzeugungseinrichtung (66) mit einer Pol- und Gegenpoloberfläche (56, 58) im Inneren des Heizofens (52) umfasst, wobei mindestens ein Chipsubstrat (12) mit mindestens einem weichmagnetischen Strukturierungselement (18) zwischen Pol- und Gegenpoloberfläche (56, 58) einlegbar ist, um eine magnetische Vorbehandlung von auf dem Chipsubstrat (12) angeordneten Widerstandselementen (14) durch ein senkrecht auf die Chipsubstratoberfläche (36) ausgerichtetes Vorbehandlungs-Magnetfeld (38) zu erreichen, wobei das weichmagnetische Strukturierungselement (18) so auf dem Chipsubstrat (12) angeordnet ist, dass ein einkoppelbares Vorbehandlungs-Magnetfeld (38) der Magnetfeld-Erzeugungseinrichtung (66) das Strukturierungselement (18) im Wesentlichen senkrecht zur Chipoberfläche (36) durchdringt und am Ort des Widerstandselementes (14) Magnetfeldkomponenten parallel zur Chipoberfläche erzeugt, die zumindest bereichsweise die ferromagnetische Schicht des Widerstandselementes (14) durchdringen, und dem weichmagnetischen Strukturierungselement (18) zwei oder mehrere Widerstandselemente (14) zugeordnet sind, um eine permanente Magnetisierung der zumindest einen ferromagnetischen Schicht der Widerstandselemente (14) in die gleiche oder in verschiedene, parallel zur Chipsubstratoberfläche (36) liegende Richtung auf Basis des Vorbehandlungs-Magnetfeld (38) der Magnetfeld-Erzeugungseinrichtung (66) vorzunehmen.

11. .Magnetfeld-Vorbehandlungsvorrichtung (50) nach Anspruch 10, **dadurch gekennzeichnet, dass** die Magnetfeld-Erzeugungseinrichtung (66) einen Permanentmagneten (68) umfasst, der im Heizofen (52) angeordnet ist, wobei eine Stärke des Vorbehandlungs-Magnetfeldes (38) über einen einstellbaren Luftspalt (34) zwischen Permanentmagnet (68) und Pol- und Gegenpoloberfläche (56, 58) mittels einer Luftspalt-Einstelleinrichtung (60) einstellbar ist.

## Claims

1. Method for permanent magnetization of at least one ferromagnetic layer in a magnetic field sensor device (10) deposited onto a chip substrate (12), comprising the steps:
- manufacture of at least one magnetoresistive resistance element (14) on a chip substrate (12) which comprises at least one ferromagnetic layer and at least one antiferromagnetic layer, an exchange coupling being effective between the ferromagnetic and antiferromagnetic layers which disappears when the blocking temperature is reached;
- deposition of at least one soft magnetic structuring element (18) onto the chip substrate (12) adjacent to or partially overlapping the resistance element (14);
- heating of the resistance element (14) to above the blocking temperature of the material of the antiferromagnetic layer and coupling of a magnetic pretreatment field (38);
- cooling of the resistance element (14) to below the blocking temperature;
- removal of the magnetic pretreatment field (38), the soft magnetic structuring element (18) being arranged such that the coupled magnetic pretreatment field (38) penetrates the structuring element (18) substantially perpendicular to the chip surface (36) and generates at the location of the resistance element (14) magnetic field components parallel to the chip surface that penetrate at least in some areas the ferromagnetic layer of the resistance element (14), **characterized in that** two or more resistance elements (14) are associated with the soft magnetic structuring element (18) in order to provide a permanent magnetization of the at least one ferromagnetic layer of the resistance elements (14) in the same direction or in different directions parallel to the chip substrate surface (36).

2. Method according to claim 1, **characterized in that** the set magnetization directions of the ferromagnetic layers of the resistance element (14) are either parallel or antiparallel to one another.

3. Method according to one of the preceding claims, **characterized in that** the at least two or more resistance elements (14) are usable to form a Wheatstone bridge (24), preferably to form at least one upper or lower bridge section (28, 30) of a Wheatstone bridge (24).

4. Method according to one of the preceding claims, **characterized in that** the resistance elements (14) comprise GMR layer systems and/or TMR layer systems.

5. Method according to one of the preceding claims, **characterized in that** at least one boundary edge (20) of the soft magnetic structuring element (18) is substantially parallel or tangential to a boundary edge (22) of a resistance element (14), the resistance element (14) being covered in some areas by the soft magnetic structuring element (18), and the coverage having a dimension of 5 µm or less.

6. Method according to one of the preceding claims, **characterized in that** the structuring element (18) is formed in such a way that the flux density of the emerging stray magnetic fields (46) is guided and reinforced preferably by pronounced pole shoes (72) or flux guidance recesses (74) in the structuring element.

7. Method according to one of the preceding claims, **characterized in that** the resistance elements (14) are insulated from the soft magnetic structuring element (18) by an insulation layer (76), in particular a layer of SiN or Al₂O₃ with a thickness of 30 nm to 5 µm.

8. Method according to one of the preceding claims, **characterized in that** the soft magnetic structuring element (18) is manufactured by depositing or building up a layer of soft magnetic material on the chip substrate (12), in particular NiFe with a layer thickness of 1000 nm to 20 µm, preferably by an electrogalvanic deposition method and lithographic structuring methods for structuring individual soft magnetic structuring elements (18).

9. Method according to one of the preceding claims, **characterized in that,** on completion of the pinning process, the soft magnetic structuring element(s) (18) are removed from the chip substrate (12).

10. Magnetic field pretreatment device (50) for permanent magnetization (pinning) of at least one ferromagnetic layer of resistance elements (14) of a magnetic field sensor device (10) deposited onto a chip substrate (12) by an above method, **characterized in that** the magnetic field pretreatment device (50) comprises a furnace (52) and a magnetic field generating device (66) with pole and opposite pole surfaces (56, 58) in the interior of the furnace (52), at least one chip substrate (12) being insertable with at least one soft magnetic structuring element (18) between the pole and opposite pole surfaces (56, 58) in order to achieve a magnetic pretreatment of resistance elements (14) arranged on the chip substrate (12) by a magnetic pretreatment field (38) aligned perpendicular to the chip substrate surface (36); the soft magnetic structuring element (18) being arranged on the chip substrate (12) such that a couplable magnetic pretreatment field (38) of the magnetic field generating device (66) penetrates the structuring element (18) substantially perpendicular to the chip surface (36) and generates at the location of the resistance element (14) magnetic field components parallel to the chip surface which penetrate the ferromagnetic layer of the resistance element (14) at least in some areas, and two or more resistance elements (14) being associated with the soft magnetic structuring element (18) in order to provide permanent magnetization of the at least one ferromagnetic layer of the resistance elements (14) in the same direction or in different directions parallel to the chip substrate surface (36) on the basis of the magnetic pretreatment field (38) of the magnetic field generating device (66).

11. Magnetic field pretreatment device (50) according to claim 10, **characterized in that** the magnetic field generating device (66) comprises a permanent magnet (68) which is arranged in the furnace (52), a strength of the magnetic pretreatment field (38) being settable by a settable air gap (34) between the permanent magnet (68) and the pole and opposite pole surfaces (56, 58) by means of an air gap setting device (60).

## Revendications

1. Procédé pour l'aimantation permanente d'au moins une couche ferromagnétique dans un dispositif à capteur de champ magnétique (10) monté sur un substrat de puce (12), comprenant les étapes suivantes :
- Fabrication d'au moins un élément magnéto-résistif (14) sur un substrat de puce (12) qui comprend au moins une couche ferromagnétique et au moins une couche antiferromagnétique, sachant qu'entre la couche ferromagnétique et la couche antiferromagnétique agit un couplage d'échange qui disparaît une fois la température de blocage atteinte;
- Montage d'au moins un élément de motif (18), magnétique doux sur le substrat de puce (12) dans le voisinage ou chevauchant partiellement l'élément résistif (14) ;
- Chauffage de l'élément résistif (14) au-dessus de la température de blocage du matériau de la couche antiferromagnétique et couplage d'un champ magnétique de prétraitement (38) ;
- Refroidissement de l'élément résistif (14) en dessous de la température de blocage ;
- Suppression du champ magnétique de prétraitement (38), sachant que l'élément de motif (18), magnétique doux est disposé de telle sorte que le champ magnétique de prétraitement couplé (38) pénètre dans l'élément de motif (18) essentiellement verticalement par rapport à la surface de puce (36) et produit, à l'emplacement de l'élément résistif (14), des composantes de champ magnétique parallèles à la surface de la puce qui pénètrent au moins partiellement dans la couche ferromagnétique de l'élément résistif (14),
**caractérisé en ce que** deux éléments résistifs (14) ou plus sont associés à l'élément de motif (18), magnétique doux pour procéder à une aimantation permanente de ladite au moins une couche ferromagnétique des éléments résistifs (14) dans le même sens ou dans un sens différent, parallèle à la surface du substrat de puce (36).

2. Procédé selon la revendication 1, **caractérisé en ce que** les sens d'aimantation réglés des couches ferromagnétiques des éléments résistifs (14) sont soit parallèles soit antiparallèles les uns par rapport aux autres.

3. Procédé selon au moins une des revendications précédentes, **caractérisé en ce que** lesdits au moins deux éléments résistifs (14) ou plus sont utilisables pour former un pont de Wheatstone (24), de préférence pour former une branche supérieure ou inférieure (28, 30) d'un pont de Wheatstone (24).

4. Procédé selon une des revendications précédentes, **caractérisé en ce que** les éléments résistifs (14) comprennent des systèmes de couches GMR et/ou des systèmes de couches TMR.

5. Procédé selon une des revendications précédentes, **caractérisé en ce qu'**au moins un bord du contour (20) de l'élément de motif (18), magnétique doux s'étend essentiellement parallèlement ou tangentiellement par rapport au bord du contour (22) d'un élément résistif (14), sachant que l'élément résistif (14) est recouvert partiellement par l'élément de motif (18), magnétique doux, et sachant que le recouvrement mesure 5 µm ou moins.

6. Procédé selon une des revendications précédentes, **caractérisé en ce que** l'élément de motif (18) est formé de manière à ce que la densité des champs magnétiques de dispersion (46) se produisant est de préférence conduite et amplifiée dans l'élément de motif par des pièces polaires (72) saillantes ou des évidements de guidage de flux (74).

7. Procédé selon une des revendications précédentes, **caractérisé en ce que** les éléments résistifs (14) sont isolés de l'élément de motif (18), magnétique doux par une couche d'isolation (76), notamment par une couche de SiN ou Al2O3 d'une épaisseur comprise entre 30 nm et 5 µm.

8. Procédé selon une des revendications précédentes, **caractérisé en ce que** l'élément de motif (18), magnétique doux est fabriqué en déposant ou formant une couche de matériau magnétique doux sur le substrat de puce (12), notamment de NiFe d'une épaisseur comprise entre 1000 nm et 20 µm, de préférence au moyen d'un procédé de dépôt électrogalvanique et d'un procédé lithographique de reproduction de motif pour réaliser des éléments de motif (18), magnétiques doux individuels.

9. Procédé selon une des revendications précédentes, **caractérisé en ce que** le ou les éléments de motif (18), magnétiques doux sont retirés du substrat de puce (12) à la fin du processus de pinning.

10. Dispositif de prétraitement à champ magnétique (50) pour l'aimantation permanente (pinning) d'au moins une couche ferromagnétique d'éléments résistifs (14) d'un dispositif à capteur de champ magnétique (10), montés sur un substrat de puce (12) par un procédé pré-cité, **caractérisé en ce que** le dispositif de prétraitement à champ magnétique (50) comprend un four (52) et un dispositif de génération de champ magnétique (66) avec une surface polaire et antipolaire (56, 58) à l'intérieur du four (52), sachant qu'au moins un substrat de puce (12) avec au moins un élément de motif (18), magnétique doux est insérable entre la surface polaire et antipolaire pour (56, 58) obtenir un prétraitement magnétique des éléments résistifs (14) disposés sur le substrat de puce (12), par un champ magnétique de prétraitement (38) dirigé vers la surface du substrat de puce (36), sachant que l'élément de motif (18), magnétique doux est disposé sur le substrat de puce (12) de sorte qu'un champ magnétique de prétraitement (38) du dispositif de génération de champ magnétique (66), pouvant être couplé pénètre dans l'élément de motif (18) essentiellement verticalement par rapport à la surface de puce (36) et génère à l'emplacement de l'élément résistif (14) des composantes de champs magnétiques parallèles à la surface de la puce qui pénètrent au moins partiellement dans la couche ferromagnétique de l'élément résistif (14) et que deux éléments résistifs ou plus (14) sont associés à l'élément de motif (18) magnétique doux pour procéder à une aimantation permanente de la dite au moins une couche ferromagnétique des éléments résistifs (14) dans le même sens ou dans des sens différents, parallèles à la surface du substrat de puce (36) sur la base du champ magnétique de prétraitement (38) du dispositif de génération de champ magnétique (66).

11. Dispositif de prétraitement à champ magnétique (50) selon la revendication 10, **caractérisé en ce que** le dispositif de génération de champ magnétique (66) comprend un aimant permanent (68) qui est disposé dans le four (52), sachant qu'une intensité du champ magnétique de prétraitement (38) est réglable par le biais d'un entrefer (34) situé entre l'aimant permanent (68) et la surface polaire et antipolaire (56, 58), réglable au moyen d'un dispositif de réglage de l'entrefer (60).
